(19)

Europäisches
Patentamt
European
Patent Office
Office européen
des brevets

(11) **EP 1 746 710 A2**

(12) **EUROPEAN PATENT APPLICATION**

(43) Date of publication:
**24.01.2007 Bulletin 2007/04**

(51) Int Cl.:
*H02M 3/07* (2006.01)

(21) Application number: **06117560.0**

(22) Date of filing: **20.07.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **20.07.2005 US 186000**

(71) Applicant: **M/A-COM, INC.**
**Lowell, MA 01854 (US)**

(72) Inventors:
• **Abbasi, Saeed**
**Narberth, NJ 19072 (US)**
• **Fang, Yi**
**Martinsville, NJ 08836 (US)**

(74) Representative: **Johnstone, Douglas Ian et al**
**Baron & Warren,**
**19 South End,**
**Kensington**
**London W8 5BU (GB)**

(54) **Charge pump apparatus, system and method.**

(57)    Apparatus, system, and method including a single common node bias voltage (316); at least a first current path (310) to drive a bias current based on the single common node bias voltage (316); at least a first current mirror to mirror the bias current in a second current path (320); and an output current path (350) comprising current drivers to drive source and sink currents that are matched to the bias current. The first current mirror may include at least one partial cascode current mirror. The apparatus and system provide a single common node bias voltage (316) to generate a bias current; mirror the bias current in at least one current path; and output well-matched output source and sink currents based on the bias current.

FIG. 3

**Description**

Some integrated circuit devices require source and sink currents. Circuits that require such source and sink currents may include any number of devices such as, for example, up/down (UP/DN) current switch elements of a charge pump, to pump source and sink currents into a phase-locked loop (PLL) circuit in response to some feedback from the PLL circuit. Charge pump type PLL circuits are widely used in modem integrated circuits. Among the various PLL topologies, the PLL charge pump is widely used because of its advantages over the traditional exclusive "OR"/low-pass filter (XOR/LPF) approach. Charge pumps used in PLL topologies control the input voltage to a voltage controlled oscillator (VCO) element of the PLL, thus controlling the VCO output frequency. Charge pumps used in PLL topologies generally require well-matched source and sink currents.

In PLL topologies, conventional charge pump circuits are generally connected to a low pass filter (LPF). However, such conventional charge pumps produce high ripples on the LPF output voltage. The ripples modulate the VCO frequency and cause distortions in the VCO's periodic waveform, even when the PLL is locked. The distortions lead to higher phase noise additional spurs in the PLL, which is not desirable for communication applications.

PLL topologies also may employ a phase frequency detector (PFD). In a conventional PLL, when in a locked position, the PFD generates narrow identical pulses at both the UP and DN outputs that control analog switches in the charge pump circuit. The narrow pulses turn on the source and sink currents to the charge pump simultaneously. As a result, the net current injected by the charge pump into the LPF (e.g., loop filter) is zero only if the net source and sink currents are matched and there are no dynamic switching mismatches. The current mismatching related to dynamic switching in source and sink networks will generally vary with the LPF voltage. Also, source and sink current mismatching varies with the channel length effect of metal oxide semiconductor (MOS) transistors, which are widely used to implement PLL circuits, including the charge pump circuit. The channel length effect may be reduced by increasing the output impedance of the source and sink current circuits using a current cascoded transistor implementation. Conventional current cascoded transistor implementations used to improve output impedance require a significant increase in overhead voltage.

The solution is provided by an apparatus comprising a single common node bias voltage, at least a first current path to drive a bias current based on the single common node bias voltage, at least a first current mirror to mirror the bias current in a second current path, wherein the first current mirror comprises at least one partial cascode current mirror, and an output current path comprising current drivers to drive source and sink currents that are matched to the bias current. Other embodiments are described and claimed.

The invention will now be described by way of example with reference to the accompanying drawings in which:

**FIG. 1** illustrates one embodiment of a circuit 100;

**FIG. 2** illustrates one embodiment of an equivalent circuit 200 of circuit 100;

**FIG. 3** illustrates one embodiment of a charge pump circuit 300;

**FIG. 4** illustrates one embodiment of a circuit 400;

**FIG. 5** illustrates one embodiment of a timing diagram for circuit 400;

**FIG. 6** illustrates one embodiment of a programmable current charge circuit 600;

**FIG. 7** illustrates one embodiment of a programmable current charge circuit 700;

**FIG. 8** illustrates one embodiment of a phase-lock loop (PLL) circuit 800; and

**FIG. 9** illustrates one embodiment of a logic flow 900.

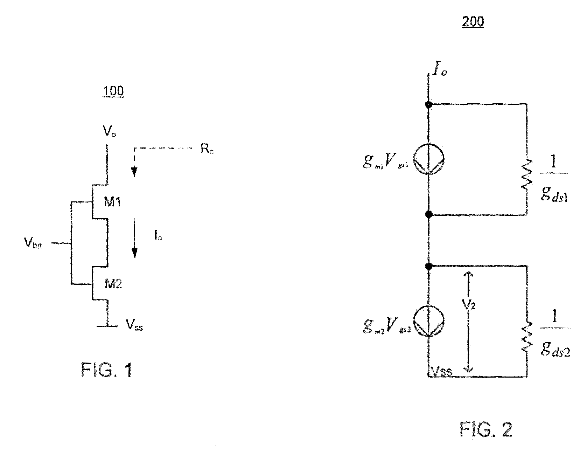

**FIG.1** illustrates one embodiment of a partial cascode circuit 100 having a high output impedance that requires less overhead voltage than a conventional fully cascode circuit element. In one embodiment, partial cascode circuit 100 may comprise a first field effect transistor (FET) M1 and a second FET M2 connected in series. The gates of M1, M2 are driven by a common bias voltage $V_{bn}$. The source of M1 is connected to the drain of M2 and the gates are connected together and are driven by a common bias voltage $V_{bn}$ at a single node. The output voltage of circuit 100 is $V_o$, the output current is $I_o$, and the output impedance is $R_o$. Although one embodiment of circuit 100 may be implemented with n-type semiconductor material FET (n-FET) elements, those skilled in the art will appreciate that embodiments of circuit 100 may be implemented using p-type semiconductor material FET (p-FET) elements, n-type or p-type semiconductor material junction-FET (p-JFET or n-JFET) elements, n-type or p-type semiconductor material MOS FET (p-MOSFET or n-MOSFET) elements, among other types of FET elements.

**FIG. 2** illustrates an equivalent circuit 200 of partial cascode circuit 100 shown in FIG. 1. The following equations characterize the operation of equivalent circuit 200, for example.

$$V_{gs1} = -V_2$$

$$V_2 = I_O * r_{2ds2}$$

$$I_O = g_{m1}(-I_O * r_{ds2}) + \frac{V_O}{r_{ds1}} - I_O \frac{r_{ds2}}{r_{ds1}}$$

$$I_O\left(1 + g_{m1}r_{ds2} + \frac{r_{ds2}}{r_{ds1}}\right) = \frac{V_O}{r_{ds1}}$$

$$R_O = \frac{V_O}{I_O}$$

$$g_{ds1} = \frac{1}{r_{ds1}}$$

$$g_{ds2} = \frac{1}{r_{ds2}}$$

$$R_O = \frac{\left(1 + g_{m1}r_{ds2} + \frac{r_{ds2}}{r_{ds1}}\right)}{r_{ds1}} \approx g_{m1}r_{ds2}r_{ds1}$$

$V_{gs1}$ is the gate-to-source voltage, $g_{m1}$ is the small-signal transconductance of M1, $r_{ds1}$ is the drain-to-source channel resistance of transistor M1, and $g_{ds1}$ is the drain-to-source channel conductance of transistor M1. $V_2$ is $V_{gs2}$, which is the gate-to-source voltage, $g_{m2}$

is the small-signal transconductance of M2, $r_{ds2}$ is the drain-to-source channel resistance of transistor M2, and $g_{ds2}$ is the drain-to-source channel conductance of transistor M2.

Referring back to FIG. 1, $V_o$ is the output voltage, $I_o$ is the output current, and $R_o$ is the output impedance of partial cascode circuit 100. The output impedance $R_o$ of partial cascode circuit 100 may be increased by the common gate voltage gain of transistor M1, $g_{m1}$, without increasing the overhead voltage required by a conventional full cascode circuit. Thus, partial cascode circuit 100 may be used to implement charge pump current source and sink circuits having an output impedance of $R_o$, where $R_o$ may be increased by the common gate voltage gain of transistor M1, $g_{m1}$ without the significant penalty of an increase in the overhead voltage, for example.

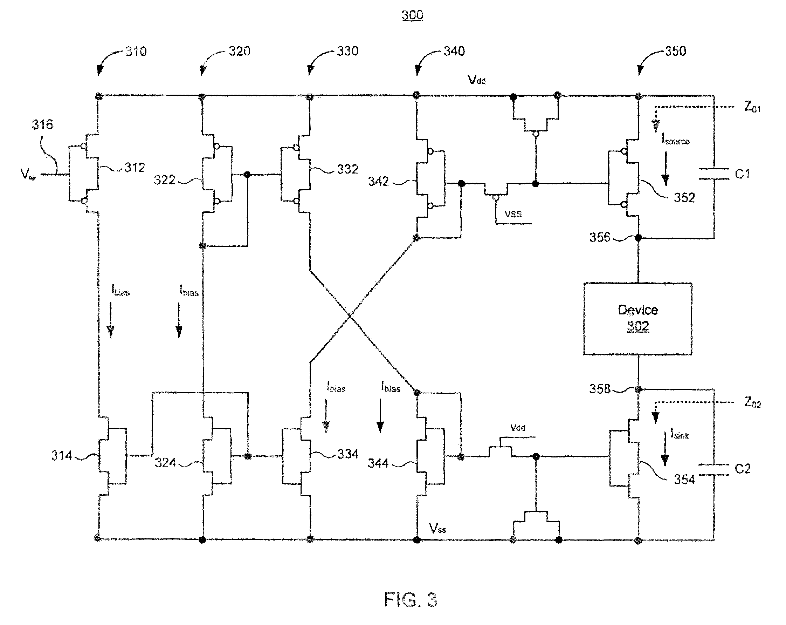

**FIG. 3** illustrates one embodiment of a charge pump circuit 300 that provides well-matched source and sink currents $I_{source}$, $I_{sink}$, respectively, from a common bias voltage node 316 to drive device 302. In one embodiment, charge pump circuit 300 may form a portion of a charge pump circuit used in standard PLL or sigma-delta fractional-N PLL topologies, for example. Device 302 may comprise, for example, up/down (UP/DN) analog current switch elements to selectively switch source and sink currents $I_{source}$, $I_{sink}$ into a PLL circuit element in response to feedback from the PLL circuit. As illustrated, charge pump circuit 300 employs the partial cascode transistor circuit technique previously described with reference to FIGS. 1 and 2, for example. Charge pump circuit 300 also comprises common bias voltage node 316 where a single bias voltage $V_{bp}$ may be applied to charge pump circuit 300 to generate output source and sink currents $I_{source}$, $I_{sink}$. In operation, charge pump circuit 300 provides well-matched output source and sink currents $I_{source}$, $I_{sink}$ to device 302 based on the single node bias voltage $V_{bp}$ reference applied to node 316.

Employing the partial cascoded transistor technique and generating the output source and sink currents $I_{source}$, $I_{sink}$ from a common bias voltage node 316, charge pump circuit 300 delivers well-matched source and sink currents $I_{source}$, $I_{sink}$ and requires less overhead voltage as compared to fully cascoded transistor implementations and provides a higher output impedance topology. For example, charge pump circuit 300 may be implemented at least in part with partial cascode current mirrors to generate source and sink currents $I_{source}$, $I_{sink}$ that are proportional to common bias voltage $V_{bp}$ applied at node 316. The architecture of charge pump circuit 300 enforces the matching condition between sink and source currents $I_{source}$, $I_{sink}$ at output of device 302 at nodes 356, 358, for example. Charge pump circuit 300 also provides better output current performance across device 302 while source and sink current driver circuits 352, 354 remain in saturation mode over a wider range of operation and provides better performance control of phase noise or jitter and phase stability due to better matched source and sink currents $I_{source}$, $I_{sink}$. The partial cascode implementation technique also provides a charge pump circuit 300 with better tolerance to variations in temperature and in the semiconductor fabrication process.

In general, in one embodiment, charge pump circuit 300 may comprise a number of current paths 310, 320, 330, 340, 350. As illustrated, each current path 310, 320, 330, 340, 350 may comprise several partial cascode transistor elements formed using multiple n-FET and p-FET transistors, for example. Partial cascode transistors 312 generate bias current $I_{bias}$ based on input bias voltage $V_{bp}$ applied to the common gates of transistors 312 at node 316. In one embodiment, the common gates of transistors 312 form the common bias voltage node 316. The bias current $I_{bias}$ in first current path 310 is mirrored by partial cascode transistors 314. The gate of partial cascode transistors 314 are connected to the gates of partial cascode transistors 324, 334 in second and third current paths 320, 330. This mechanism forms a current mirror structure where each of the partial cascode transistors 322, 332, 342 drive bias current $I_{bias}$ through each of the second, third, and fourth current paths 320, 330, 340, respectively. The bias current $I_{bias}$ through each of the first, second, third, and fourth current paths 310, 320, 330, 340, is substantially the same and is a function of matching the partial cascode transistors 312, 314, 322, 324, 332, 334, 342, 344. The current mirror structure also drives source and sink currents $I_{source}$, $I_{sink}$ through the fifth current path 350. As illustrated, the $I_{source}$ current driven through partial cascode output transistors 352 is substantially equal to the $I_{bias}$ current. Similarly, the $I_{sink}$ current driven through partial cascode output transistors 354 is also substantially equal to the $I_{bias}$ current. Those skilled in the art will appreciate that if all the transistors in charge pump circuit 300 are formed on the same semiconductor substrate and are well-matched, then source and sink currents $I_{source}$, $I_{sink}$ are substantially well-matched and are equal to the $I_{bias}$ current. Accordingly, under matched transistor conditions:

$$I_{bias} = I_{source} = I_{sink}$$

Thus, charge pump circuit 300 provides well-matched source and sink currents $I_{source}$, $I_{sink}$ from a single bias voltage $V_{bp}$ applied to common bias voltage node 316, for example. Well-matched source and sink currents $I_{source}$, $I_{sink}$ also force the voltages at nodes 356, 358, respectively, at the input to device 302, to be substantially equal. Furthermore, the partial cascode transistor structure provides improved output impedance $Z_{01}$, $Z_{02}$ without a significant increase in the overhead voltage.

Embodiments of charge pump circuit 300 may be adapted to generate well-matched source and sink currents $I_{source}$, $I_{sink}$ that are proportional to $I_{bias}$ by appropriately scaling the current mirror elements in current paths 320, 330, 340, 350 such that:

$$I_{source} = I_{sink} \propto I_{bias}$$

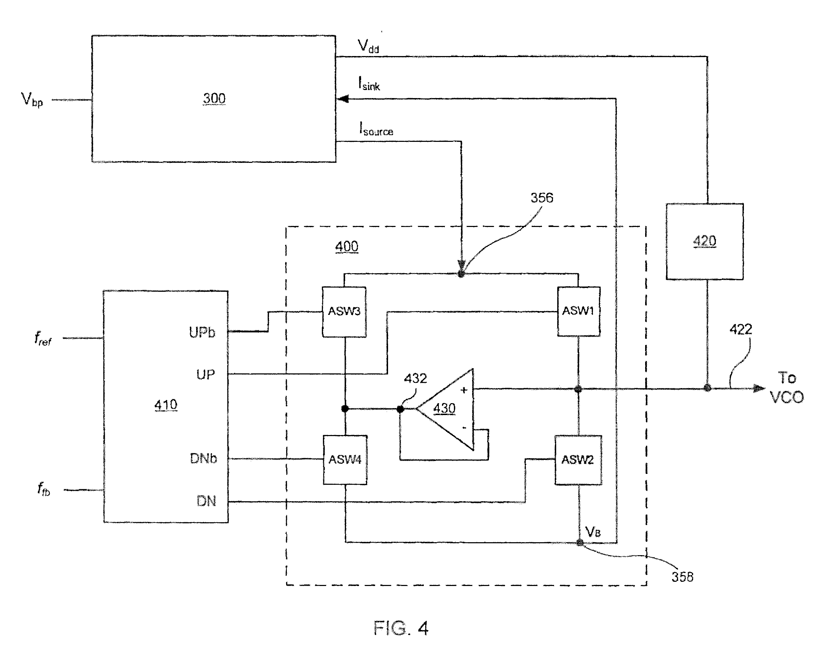

**FIG. 4** illustrates one embodiment of device 302 (FIG. 3) implemented as circuit 400. In one embodiment, circuit 400 may comprise analog switches ASW1, ASW2, ASW3, ASW4 arranged in a bridge configuration. The inputs of analog switches ASW1, ASW3 are connected to node 356 and to the current source $I_{source}$ node of charge pump circuit 300. The output of ASW1 is connected to the input on ASW2 and the output of ASW3 is connected to the input of ASW4. The outputs of ASW2, ASW4 are connected to node 358 and to the sink current node $I_{sink}$ of charge pump circuit 300. The analog switches ASW1, ASW2, ASW3, ASW4 are controlled by outputs UP, DN, UPb, DNb, respectively, of device 410, which in one embodiment may comprise a phase/frequency detector (PFD), for example.

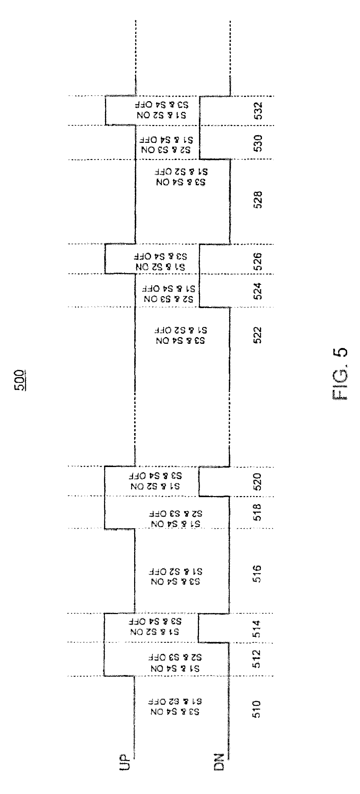

In operation, charge pump circuit 300 sources and sinks currents $I_{source}$, $I_{sink}$ to and from circuit 400. In one embodiment, output source current $I_{source}$ is driven into node 356 and output sink current $I_{sink}$ is driven from node 358. Source current $I_{source}$ is driven to the inputs of analog switches ASW1, ASW3. Sink current $I_{sink}$ is driven from analog switches ASW2, ASW4 from node 358. Operational amplifier 430 is common mode biased to provide matching current capability at its output 432 where it drives a dummy load. In one embodiment, device 420 may be a low pass filter that feeds a VCO in standard PLL or sigma-delta fractional-N PLL circuits, for example. The operation of operational amplifier 430 and one embodiment of a technique for driving a dummy load is described below with reference to FIG. 5.

**FIG. 5** illustrates one example of a timing diagram 500. With reference to the circuits described FIGS. 3, 4, timing diagram 500 illustrates the operation of analog switches ASW1, ASW2, ASW3, ASW4 through the outputs UP, DN, UPb, DNb, respectively, of device 410, implemented as a PFD, for example, and the operation of operational amplifier 430 for driving a dummy load. The UPb output is the inverse of the UP output and the DNb output is the inverse of the DN output. In one embodiment, analog switches ASW1, ASW2, ASW3, ASW4 may be operated such that there is no discontinuity in the source and sink currents $I_{source}$, $I_{sink}$, for example, when source and sink current drivers 352, 354 (FIG. 3) are turned off.

Accordingly, in periods 510, 516, 522, 528, UP/DN outputs are logic low and UPb/DNb outputs are logic high, thus analog switches ASW3/ASW4 are turned on and conduct source and sink currents $I_{source}$, $I_{sink}$ while analog switches ASW1/ASW2 are turned off and do not conduct any current.

In periods 512, 518, UP/DNb outputs are logic high and UPb/DN outputs are logic low. Thus analog switches ASW1/ASW4 are turned on and conduct current while analog switches ASW2/ASW3 are turned off and do not conduct current. During periods 512, 518, operational amplifier 430 drives sink current $I_{sink}$ to charge pump circuit 300 via ASW4. Charge pump circuit 300 drives source current $I_{source}$ to circuit 420 via ASW1.

In periods 514, 520, 526, 532, UP/DN outputs are logic high and UPb/DNb outputs are logic low. Thus, analog switches ASW1/ASW2 are turned on and conduct source and sink currents $I_{source}$, $I_{sink}$ while analog switches ASW3/ASW4 are turned off and do not conduct any current.

In periods 524, 530 UP/DNb outputs are logic low and UPb/DN outputs are logic high. Thus, analog switches ASW2/ASW3 are turned on and conduct current while analog switches ASW1/ASW4 are turned off and do not conduct current. During periods 524, 530, operational amplifier 430 drives source current $I_{source}$ from charge pump circuit 300 via ASW3. Charge pump circuit 300 drives current $I_{sink}$ from circuit 420 via ASW2.

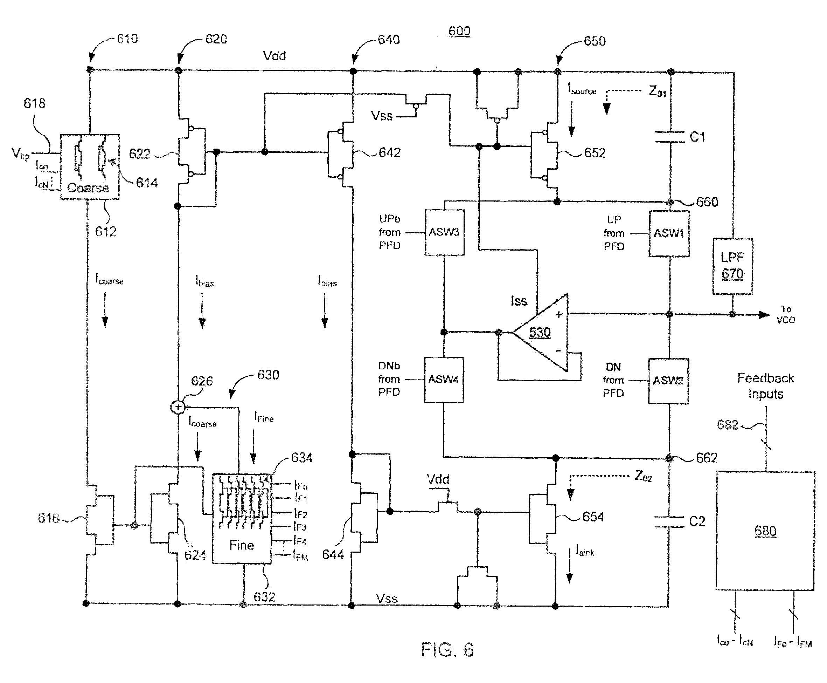

FIG. 6 illustrates one embodiment of a programmable current charge pump circuit 600 comprising current programming elements 612, 632. In one embodiment, programming element 612 is digitally programmable to provide a coarse current output, $I_{coarse}$, and programming element 632 is digitally programmable to provide a fine current output, $I_{fine}$. In one embodiment, charge pump output source and sink currents $I_{source}$ and $I_{sink}$ may be selectively and dynamically changed through current programming elements 612, 632 to change the gain of various components of the PLL, such as for example, changing the gain of a PFD (not shown). In one embodiment, current programming elements 612, 632 may be used to program charge pump output source and sink currents $I_{source}$ and $I_{sink}$ over a wide range. In one embodiment, current programming elements 612, 632 may be programmed by an automatic phase alignment device 680 (APAD) provided in a feedback path of a sigma-delta fractional-N PLL, for example. In one embodiment, APAD 680 receives parameter settings stored in a look-up table at inputs 682. In one embodiment, APAD 680 receives phase alignment information in the form of inputs 682 from the look-up table and generates digital outputs $I_{co}$ — $I_{cN}$ and $I_{F0}$ — $I_{FM}$ to program coarse and fine current programming elements 612, 632, respectively. In one embodiment, the coarse and fine currents $I_{coarse}$, $I_{fme}$ may be dynamically programmed based on the parameter settings stored in the look-up table provided to APAD 680 at inputs 682 and source and sink currents $I_{source}$, $I_{sink}$ are programmed accordingly.

In one embodiment, programmable current charge pump circuit 600 may be employed in a sigma-delta fractional-N PLL where a wider range PFD gain (KPD) may be desired. In such embodiments, coarse and fine programmable elements 612, 632 dynamically adjust the source and sink currents $I_{source}$ and $I_{sink}$ in current

path 650 to compensate for any nonlinearity in VCO gain (KVCO), or other components of a sigma-delta fractional-N PLL. Charge pump circuit 600 also provides well-matched output source and sink currents $I_{source}$, $I_{sink}$ in current path 650 by referencing these currents back to a single node bias voltage $V_{bp}$ applied at node 618. This technique provides source and sink currents $I_{source}$, $I_{sink}$ with improved tolerance to variations in the semiconductor manufacturing process and temperature.

In general, programmable current charge pump circuit 600 comprises a number of current paths 610, 620, 630, 640, 650. Each current path 610, 620, 630, 640, 650 may comprise several partial cascode n-FET and p-FET transistor elements. Coarse programmable current element 612 is provided in first current path 610 to coarsely set coarse current $I_{coarse}$ in current path 610. In one embodiment, coarse programmable current element 612 may comprise multiple common gate partial cascode transistors 614 in parallel. Coarse current $I_{coarse}$ in current path 610 is proportional to $V_{bp}$ applied to node 618 and the sum total of the current in each of the parallel partial cascode transistors 614 selected by way of digital control inputs $I_{c0}$ - $I_{cN}$. Thus, the number of partial cascode transistors 614 contributing to coarse current $I_{coarse}$ may be digitally programmable by way of digital control inputs $I_{co}$ - $I_{cN}$. The value of the digital control inputs $I_{co}$ - $I_{cN}$ determines how many parallel partial cascode transistors 614 are selected to contribute to $I_{coarse}$. Coarse current $I_{coarse}$ also depends upon the input bias voltage $V_{bp}$ at node 618, which is applied to the common gates of partial cascode transistors 614 of coarse programmable current element 612. In one embodiment, bias voltage input $V_{bp}$ forms a common bias voltage node 618 to control source and sink currents $I_{source}$ and $I_{sink}$ in current path 650.

The programmed coarse current $I_{coarse}$ in first current path 610 is mirrored by partial cascode transistors 616. The common gates of partial cascode transistors 616 are connected to the gates of partial cascode transistors 624 in second current path 620, which also drives coarse current $I_{coarse}$. Second current path 620 and third current path 630 are connected to node 626. Third current path 630 includes fine programmable current element 632 to drive fine current $I_{fine}$ in third current path 630. Fine programmable current element 632 comprises multiple common gate partial cascode transistors 634 to select the amount of fine current $I_{fine}$ driven in current path 630. As previously discussed, fine current $I_{fine}$ may be digitally controlled by applying a digital code at inputs $I_{F0}$ — $I_{FM}$ to select a number of parallel transistors 634. The gates of partial cascode transistors 624 are connected to the common gates of partial cascode transistors 634. The current mirror mechanism drives coarse current $I_{coarse}$ through partial cascode transistors 624. Partial cascode transistors 622 drive bias current $I_{bias}$ into node 626 is equal to the sum of currents $I_{coarse}$ and $I_{fine}$ out of node 626. Fine current $I_{fine}$ may be programmed such that if all inputs $I_{F0}$ - $I_{FM}$ are logic low, then $I_{fine}$ is zero because none of the partial cascode transistors 624 are selected and $I_{bias} = I_{coarse}$. On the other hand, if all inputs $I_{F0}$ — $I_{FM}$ are logic high, then all partial cascode transistors 624 are selected and $I_{fine}$ is set to a predetermined maximum and $I_{bias} = I_{bias} + I_{fineMAX}$. Other combinations of fine current $I_{fine}$ may be programmed with the appropriate value at the digital control inputs $I_{F0} - I_{FM}$, for example.

Fourth current path 640 drives bias current $I_{bias}$ through partial cascode transistors 642, 644. The current mirror mechanism also drives currents $I_{source}$ and $I_{sink}$ through fifth parallel current path 650. As illustrated, $I_{source}$ is driven by partial cascode output transistors 652 and is equal to bias current $I_{bias}$. Similarly, $I_{sink}$ is driven by partial cascode output transistors 654 and also is equal to bias current $I_{bias}$. Those skilled in the art will appreciate that if all the transistors in programmable current charge pump circuit 600 are well-matched, it follows that currents $I_{source}$ and $I_{sink}$ are equal to bias current $I_{bias}$ and, thus, bias current $I_{bias}$ is well-matched to $I_{source}$ and $I_{sink}$. Accordingly, assuming matched transistor conditions:

$$I_{sink} = I_{source} = I_{bias} \; ;$$

where
$$I_{bias} = I_{coarse} + I_{fine}$$

Controlling the input bias voltage $V_{bp}$ at common bias voltage node 618 and programming the current $I_{bias}$ provides well-matched source and sink output currents $I_{source}$ and $I_{sink}$, for example.

Well-matched source and sink currents $I_{source}$ and $I_{sink}$ forces equal voltage potentials at nodes 660, 662. The output of LPF 670 then may be provided to other stages of a sigma-delta fractional-N PLL circuit, such as, for example, the VCO. In one embodiment, a sigma-delta fractional-N PLL also may comprise the APAD 680 in its feedback path. APAD 680 receives phase alignment information in the form of inputs 682 and generates digital outputs $I_{co}$ — $I_{cN}$ and $I_{F0}$ — $I_{FM}$ to program coarse and fine current programming elements 612 and 634, respectively.

As discussed previously with respect to FIG.3, employing the partial cascode transistor structures provides improved output impedance $Z_{01}$, $Z_{02}$ without a significant increase in the overhead voltage.

Embodiments of charge pump circuit 600 also may be adapted to generate output currents $I_{source}$ and $I_{sink}$ that are well-matched and proportional to $I_{bias}$ by appropriately scaling current mirror elements in parallel current paths 620, 630, 640 such that:
$$I_{source} = I_{sink} \propto I_{bias}$$

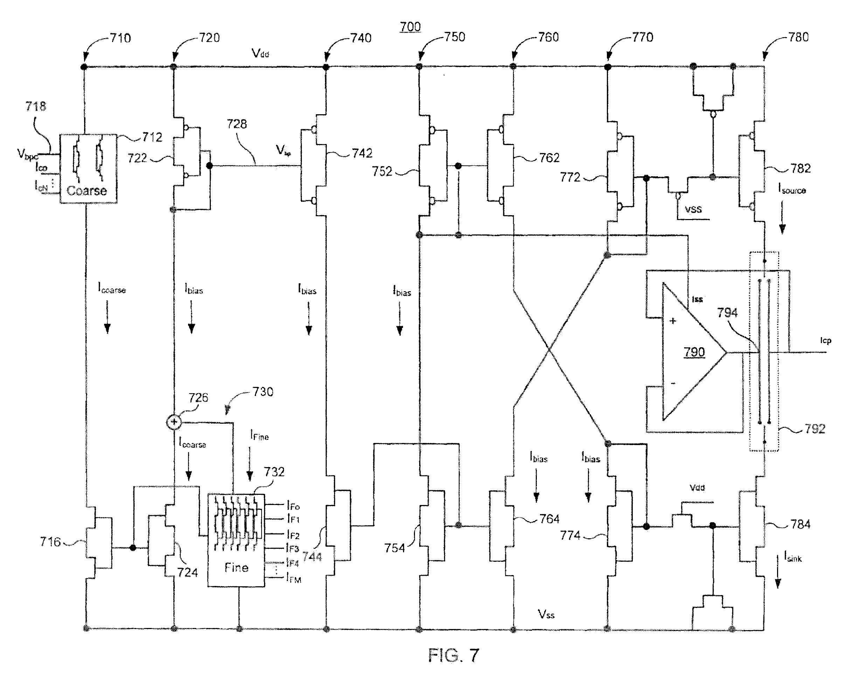

**FIG. 7** illustrates one embodiment of a programmable current charge pump circuit 700 comprising current programming elements 712, 732. As previously described with reference to FIG. 6, in one embodiment, the charge pump source and sink output currents $I_{source}$ and $I_{sink}$ may be selectively and dynamically programmed with elements 712, 732 to change the gain of various components of the PLL, such as for example, changing the gain of a PFD (not shown). In one embodiment, the programmable current charge pump circuit 700 may be employed in sigma-delta fractional-N PLL applications if a wider range PFD gain (KPD) is desired. Coarse and fine programmable elements 712, 732 dynamically adjust coarse current $I_{coarse}$ and fine current $I_{fine}$ in current paths 710, 730, which is then mirrored to source and sink currents $I_{source}$ and $I_{sink}$ in current path path 780 to compensate for any nonlinearity in VCO gain (KVCO), or other components of sigma-delta fractional-N PLL circuits. Programmable current charge pump circuit 700 also provides well-matched output source and sink currents $I_{source}$, $I_{sink}$ in current path 780 by referencing these currents from bias voltage $V_{bpc}$ applied at single node 718. This technique provides source and sink currents $I_{source}$ and $I_{sink}$ with improved tolerance to variations in the semiconductor manufacturing process and temperature.

In general, programmable current charge pump circuit 700 comprises a number of current paths 710, 720, 730, 740, 750, 760, 770, 780. As illustrated, each current path may comprise several partial cascode n-FET and p-FET transistor elements. A coarse programmable current element 712 is provided in the first parallel current path 710 to set coarse current $I_{coarse}$.

The operation of programmable current charge pump circuit 700 is substantially similar to the operation of programmable current charge pump circuit 600 in FIG. 6. The bias voltage $V_{pbc}$ and coarse programmable current element 712 drives $I_{coarse}$ in current path 710 through partial cascode current mirror 716. Accordingly, $I_{coarse}$ is driven by partial cascode current mirror 724 and $I_{fine}$ is digitally programmed by fine programmable current element 732. Thus $I_{bias}$ is driven by partial cascode transistors 722 into node 726 of current path 720 and is equal to the sum of $I_{coarse}$ and $I_{fine}$ driven out of node 726. Partial cascode current mirrors 744, 754, 764, and 774 drive $I_{bias}$ through partial cascode transistors 742, 752, 772, 762, respectively. Accordingly, output source and sink currents $I_{source}$, $I_{sink}$ driven by partial cascode output transistors 782, 784, respectively, are matched to $I_{bias}$, which is programmable via coarse and fine programmable current elements 712, 732 and is a function of bias voltage $V_{bpc}$ applied at single common bias node 718.

As previously described with respect to FIGS. 4-6, in charge pump operation, operational amplifier 790 drives dummy load 794 through selected legs of analog switch bridge 792 during certain timing cycles set by the PFD (not shown). Driving the dummy load prevents discontinuities of source and sink currents $I_{source}$ and $I_{sink}$ in current path 780. Furthermore, the bias voltage node 728 provides a bias voltage reference point $V_{bp}$ that is relatively clean, i.e., without any switching noise. Thus, source and sink currents $I_{source}$, $I_{sink}$ in current path 780 are much cleaner and well-matched.

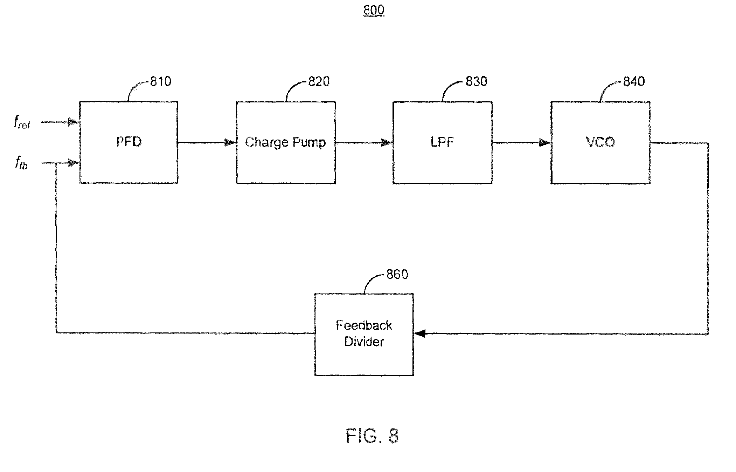

FIG. 8 illustrates one embodiment of a PLL circuit 800. In general, PLL circuit 800 comprises PFD 810, charge pump 820, LPF 830, and VCO 840. The PFD 810 receives a reference frequency $f_{ref}$ and a feedback frequency $f_{fb}$ from feedback loop divider 860. Charge pump 820 may be implemented as any one of charge pump circuits 300, 400, 600, 700, 800 described with reference to FIGS. 3, 4, 6, 7, 8, respectively.

Operations for the above system and subsystem may be further described with reference to the following figures and accompanying examples. Some of the figures may include programming logic. Although such figures presented herein may include a particular programming logic, it can be appreciated that the programming logic merely provides an example of how the general functionality described herein can be implemented. Further, the given programming logic does not necessarily have to be executed in the order presented unless otherwise indicated. In addition, the given programming logic may be implemented by a hardware element, a software element executed by a processor, or any combination thereof.

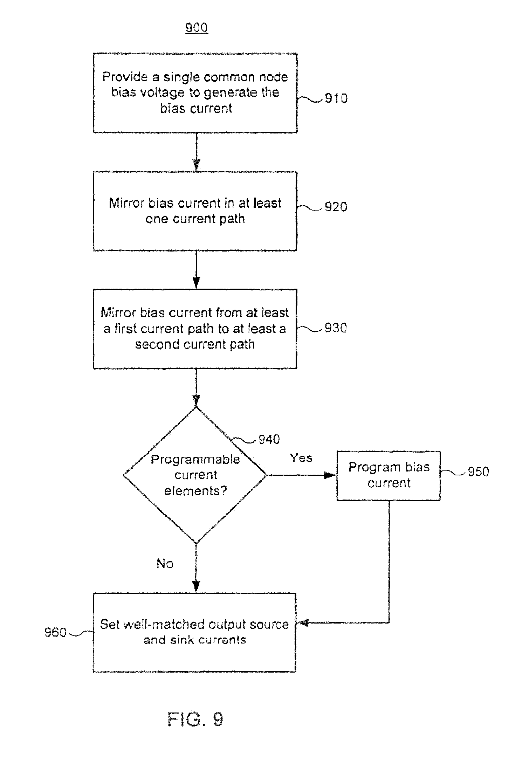

FIG. 9 illustrates one embodiment of a logic flow 900 for providing well-matched source and sink currents $I_{source}$, $I_{sink}$ from a single bias voltage $V_{bp}$ applied at a common node in charge pump circuits 300, 400, 600, 700, 800, for example. In one embodiment, the logic flow 900 may be executed using the charge pump circuits shown in any of FIGS. 3, 4, 6-8.

Logic flow 900 provides 910 a single common node bias voltage reference $V_{bp}$ to generate a bias current $I_{bias}$. Logic flow 900 continues to mirror 920 bias current $I_{bias}$ in at least one current path of a number of current paths of a circuit. Bias current $I_{bias}$ also may be mirrored 930 from at least a first current path to a second and multiple other current paths in the circuit.

Logic flow 900 continues at decision block 940 where it is determined whether the circuit comprises programmable current elements. If the circuit comprises programmable current elements, the logic flow 900 proceeds along "yes" branch and programs 950 bias current $I_{bias}$ based on feedback from the circuit, such as for example, feedback from a phase alignment circuit in a PLL circuit. Bias current $I_{bias}$ may be coarsely and finely adjusted depending on specific embodiments of the circuit.

If the circuit does not include current programming capabilities, logic flow 900 proceeds along "No" branch from decision block 940. Logic flow 900 continues with setting 960 well-matched output source and sink currents $I_{source}$, $I_{sink}$ in an output current path, which are mirrored from $I_{bias}$ and depend upon a single bias voltage $V_{bp}$ applied at a common node of the circuit. In one embodiment, the source and sink currents $I_{source}$, $I_{sink}$ may be output from a charge pump circuit in a PLL in response to feedback received from the PLL.

Numerous specific details have been set forth herein to provide a thorough understanding of the embodiments. It will be understood by those skilled in the art, however, that the embodiments may be practiced without these specific details. In other instances, well-known operations, components and circuits have not been described in detail so as not to obscure the embodiments. It can be appreciated that the specific structural and functional details disclosed herein may be representative and do not necessarily limit the scope of the embodiments.

It is also worthy to note that any reference to "one embodiment" or "an embodiment" means that a particular feature, structure, or characteristic described in connection with the embodiment is included in at least one embodiment. The appearances of the phrase "in one embodiment" in various places in the specification are not necessarily all referring to the same embodiment.

Some embodiments may be implemented using an architecture that may vary in accordance with any number of factors, such as desired speed, power levels, heat tolerances, semiconductor manufacturing processing, input rates, output rates, memory resources, and other performance constraints.

Some embodiments may be described using the expression "coupled" and "connected" along with their derivatives. It should be understood that these terms are not intended as synonyms for each other. For example, some embodiments may be described using the term "connected" to indicate that two or more elements are in direct physical or electrical contact with each other. In another example, some embodiments may be described using the term "coupled" to indicate that two or more elements are in direct physical or electrical contact. The term "coupled," however, may also mean that two or more elements are not in direct contact with each other, but yet still co-operate or interact with each other.

**Claims**

1. An apparatus (300), comprising:

    a single common node bias voltage (316);
    at least a first current path (310) to drive a bias current based on said single common node bias voltage (316);
    at least a first current mirror to mirror said bias current in a second current path (320), wherein said first current mirror comprises at least one partial cascode current mirror; and
an output current path (350) comprising current drivers to drive source and sink currents that are matched to said bias current.

2. The apparatus of claim 1, comprising:

an analog switch bridge (400) coupled to said output current path (350) to receive said source and sink output currents; and
an operational amplifier (430) coupled to said analog switch bridge (400) to drive a load when said source and sink current drivers are turned off.

3. The apparatus of claim 2, wherein said operational amplifier (430) maintains the same voltage at source and sink nodes of said analog switch bridge (400).

4. The apparatus of claim 2, comprising a phase-frequency detector (410) coupled to said analog switch bridge (400), wherein said phase-frequency detector controls said analog switches (ASW1, ASW2, ASW3, ASW4) to source and sink said source and sink currents in response to feedback from a phase-locked loop circuit.

5. The apparatus of claim 1, comprising a first programmable current element (612) in said first current path to control said bias current.

6. The apparatus of claim 5, comprising a second programmable current element (632) in a third current path to control said bias current.

7. The apparatus of claim 6, wherein said first programmable current element (612) provides a coarse adjustment for said bias current and said second programmable current element (632) provides a fine adjustment for said bias current.

8. The apparatus of claim 6, wherein at least one of said first and second programmable current elements (612, 632) is digitally programmed in response to feedback from a phase-locked loop circuit.

EP 1 746 710 A2

100

FIG. 1

200

FIG. 2

FIG. 3

EP 1 746 710 A2

FIG. 4

EP 1 746 710 A2

500

FIG. 5

FIG. 6

EP 1 746 710 A2

13

FIG. 7

EP 1 746 710 A2

14

FIG. 8

900

Provide a single common node bias voltage to generate the bias current ⌇910

↓

Mirror bias current in at least one current path ⌇920

↓

Mirror bias current from at least a first current path to at least a second current path ⌇930

↓

⌇940
Programmable current elements? →Yes→ Program bias current ⌇950

No

↓

960⌇ Set well-matched output source and sink currents ←

FIG. 9